# EUROPÄISCHE PATENTSCHRIFT

(11) **EP 1 045 973 B1**
(45) Veröffentlichungstag und Bekanntmachung des Hinweises auf die Patenterteilung: **26.11.2003**
(21) Anmeldenummer: 99947242.6
(22) Anmeldetag: 20.07.1999
(51) Int. Cl.: F02M 51/06

(54) **BRENNSTOFFEINSPRITZVENTIL**
FUEL INJECTION VALVE
SOUPAPE D'INJECTION DE CARBURANT

(30) Priorität: 26.10.1998 DE 19849203
(43) Veröffentlichungstag der Anmeldung: 25.10.2000
(73) Patentinhaber: ROBERT BOSCH GMBH, 70442 Stuttgart (DE)
(72) Erfinder: STIER, Hubert, D-71679 Asperg (DE); HOHL, Guenther, D-70569 Stuttgart (DE)
(86) Internationale Anmeldenummer: DE9902241
(87) Internationale Veröffentlichungsnummer: WO00025019

(56) Entgegenhaltungen:
- EP-A- 0 869 278
- DE-A- 19 538 791
- DE-A- 19 702 066
- US-A- 4 284 263
- US-A- 4 570 098

## Beschreibung

### Stand der Technik

Die Erfindung geht aus von einem Brennstoffeinspritzventil nach der Gattung des Hauptanspruchs. Es ist bereits aus der DE 195 38 791 A1 ein Brennstoffeinspritzventil für Brennstoffeinspritzanlagen von Brennkraftmaschinen bekannt, bei welchem ein Ventilschließkörper durch einen piezoelektrischen Aktor betätigt wird. Der piezoelektrische Aktor ist aus mehreren Piezo-Schichten aus einem piezoelektrischen Material aufgebaut. Zwischen den Piezo-Schichten befinden sich Elektroden, um die Piezo-Schichten mit einer elektrischen Spannung zu beaufschlagen und somit eine Dehnung des piezoelektrischen Aktors zu bewirken, die zur Betätigung des Ventilschließkörpers genutzt wird.

Problematisch bei der Verwendung von piezoelektrischen Aktoren ist grundsätzlich deren Temperaturausdehnung. Piezoelektrische Werkstoffe haben im Gegensatz zu üblichen Werkstoffen, wie beispielsweise Stahl oder Kunststoffen, einen negativen Temperaturausdehnungs-Koeffizienten. Dies bedingt, daß sich der piezoelektrische Aktor mit zunehmender Temperatur kontrahiert, während sich das umgebende Gehäuse ausdehnt. Die unterschiedlichen Temperaturausdehnungs-Koeffizienten des piezoelektrischen Aktors einerseits und des Gehäuses andererseits bewirken einen temperaturabhängigen Ventilhub, wenn dies nicht durch geeignete Maßnahmen kompensiert wird.

In der DE 195 38 791 A1 wird zur Temperaturkompensation vorgeschlagen, das Ventilgehäuse zweiteilig aus zwei unterschiedlichen Werkstoffen zu gestalten. Beispielsweise wird vorgeschlagen, das eine Gehäuseteil aus Stahl und das andere Gehäuseteil aus Invar zu fertigen. Durch geeignete Längenwahl des ersten Gehäuseteils aus Stahl und des zweiten Gehäuseteils aus Invar soll erreicht werden, daß die sich insgesamt ergebende Wärmedehnung des Gehäuses an die Wärmedehnung des piezoelektrischen Aktors angepaßt ist und sich somit der piezoelektrische Aktor und das den piezoelektrischen Aktor umgebende Gehäuse in gleicher Weise temperaturabhängig dehnen bzw. kontrahieren.

Nachteilig bei dieser Lösung sind jedoch die aufwendige Fertigung des Ventilgehäuses und die relativ großen Kosten für den Werkstoff des zweiten Gehäuseteils, der vorzugsweise aus Invar besteht. Ferner ist zu bedenken, daß das Ventilgehäuse und der Aktor eine unterschiedliche Temperatur aufweisen können. So kann sich der piezoelektrische Aktor aufgrund seiner Verlustwärme insbesondere bei einer häufigen Betätigung des Brennstoffeinspritzventils aufheizen und seine Temperatur nur langsam an das Ventilgehäuse übertragen. Andererseits wird die Temperatur des Ventilgehäuses durch die Abwärme der Brennkraftmaschine beeinflußt, an welcher das Brennstoffeinspritzventil montiert ist. Diese Art der Temperaturkompensation ist daher nicht befriedigend.

Beispielsweise aus der DE 195 19 192 Cl ist es bekannt, zwischen dem piezoelektrischen Aktor und der den Ventilschließkörper betätigenden Ventilnadel einen hydraulischen Hubtransformator vorzusehen. Eine Temperaturkompensation ergibt sich dann dadurch, daß der Hubtransformator nur auf relativ schnelle Bewegungsvorgänge, die zur beabsichtigten Öffnung des Brennstoffeinspritzventils führen, reagiert, während bei einer relativ langsamen, temperaturabhängigen Ausdehnung bzw. Kontraktion des piezoelektrischen Aktors die hydraulische Flüssigkeit über Führungsspalte entweichen kann. Nachteilig bei dieser Bauart ist jedoch der relativ hohe Aufwand für den hydraulischen Hubtransformator.

Weitere bekannte Temperaturkompensationen bestehen in einer Zwangstemperierung des piezoelektrischen Aktors mittels eines flüssigen oder gasförmigen Mediums, das in einem Kreislauf auf einer konstanten Temperatur gehalten wird oder in der Serienanordnung des piezoelektrischen Aktors mit einem temperaturkompensierenden Ausgleichsstück, das beispielsweise zwischen dem piezoelektrischen Aktor und einer den Ventilschließkörper betätigenden Ventilnadel angeordnet ist. während die erstgenannte Lösung relativ aufwendig ist, hat die Verwendung eines in Serie angeordneten Ausgleichsstücks den Nachteil, daß der piezoelektrische Aktor und das Ausgleichsstück, wie bereits erläutert, nicht notwendigerweise der gleichen Temperatur bzw. dem gleichen Temperaturverlauf unterworfen sind und die Temperaturkompensation daher relativ ungenau ist.

### Vorteile der Erfindung

Das erfindungsgemäße Brennstoffeinspritzventil mit dem kennzeichnenden Merkmal des Hauptanspruchs hat demgegenüber den Vorteil, daß das Brennstoffeinspritzventil eine wesentlich verbesserte Temperacurkompensation des piezoelektrischen Aktors aufweist. Erfindungsgemäß wird vorgeschlagen, unmittelbar in dem piezoelektrischen Aktor eine oder mehrere Temperaturkompensationsschichten vorzusehen, die einen Temperaturausdehnungs-Koeffizienten haben, dessen Vorzeichen dem Temperaturausdehnungs-Koeffizienten der Piezo-Schichten entgegengesetzt ist. Durch eine geeignete Wahl der Anzahl und der Schichtdicken der Temperaturkompensations-Schichten kann eine exakte Temperaturkompensation erreicht werden.

Durch die Einbettung der Temperaturkompensations-Schichten in die Piezo-Schichten des piezoelektrischen Aktors wird sichergestellt, daß die Temperaturkompensations-Schichten der gleichen Temperatur bzw. dem gleichen Temperaturverlauf unterworfen sind wie die Piezo-Schichten des Aktors. Insbesondere besteht ein großflächiger Kontakt zwischen den Piezo-Schichten und den Temperaturkompensations-Schichten, so daß eine schnelle Angleichung der Temperatur der Temperaturkompensations-Schichten an die Temperatur der Piezo-Schichten erfolgt. Dies ist wichtig, da die Verlustwärme des piezoelektrischen Aktors bei einer Variation der Betätigungsfrequenz des Brennstoffeinspritzventils infolge einer Drehzahlveränderung der Brennkraftmaschine erheblichen Schwankungen unterworfen sein kann. Aufgrund des großflächigen Kontakts der temperaturkompensierenden Schichten zu den Piezo-Schichten und der engen Nachbarschaft zu den Piezo-Schichten wird erreicht, daß die von den Temperaturkompensations-Schichten hervorgerufene Temperaturkompensation diesen Schwankungen schnell folgen kann. Auch eine Veränderung der Temperatur des Aktors durch eine schwankende Abwärme der Brennkraftmaschine kann mit der erfindungsgemäßen Lösung rasch kompensiert werden. Eine aufwendige Zwangstemperierung des piezoelektrischen Aktors ist nicht erforderlich.

Durch die in den Unteransprüchen aufgeführten Maßnahmen sind vorteilhafte Weiterbildungen und Verbesserungen des im Hauptanspruch angegebenen Brennstoffeinspritzventils möglich.

In besonders vorteilhafter Weise können die Temperaturkompensations-Schichten gleichzeitig als Elektroden zur Ansteuerung der Piezo-Schichten dienen, wenn die Temperaturkompensations-Schichten aus einem metallischen Material bestehen.

Durch die kennzeichnenden Merkmale des Hauptanspruchs wird erreicht, daß der piezoelektrische Aktor in hohem Maße temperaturkompensiert ist. Gleichwohl ist das den Aktor umgebende Ventilgehäuse, das in der Regel aus einem Metall oder einem Kunststoffmaterial besteht, dennoch einer Temperaturausdehnung unterworfen, was zu einer temperaturabhängigen Lageverschiebung des Ventilsitzkörpers gegenüber dem mit dem Aktor verbundenen Ventilschließkörper führen kann. Um dies zu vermeiden, ist erfindungsgemäß eine vorzugsweise aus einem keramischen Material bestehende Ausgleichshülse vorgesehen, die entweder den piezoelektrischen Aktor umgibt oder ihrerseits von dem piezoelektrischen Aktor umgeben wird. Der piezoelektrische Aktor stützt sich entweder über die Ausgleichshülse an dem Ventilgehäuse ab oder betätigt über die Ausgleichshülse und gegebenenfalls über eine Ventilnadel den Ventilschließkörper. Wenn die Ausgleichshülse die gleiche axiale Länge wie der piezoelektrische Aktor hat, so hat die Temperatur des Ventilgehäuses keinerlei Einfluß auf die axiale Lage des Ventilschließkörpers gegenüber der axialen Lage des Ventilsitzkörpers, d.h. es wird eine Kompensation der Temperatur des Ventilgehäuses erreicht.

Entsprechend einer ersten vorteilhaften konstruktiven Lösung ist der piezoelektrische Aktor an einem ersten Ende über eine Ventilnadel mit dem Ventilschließkörper verbunden und die Ausgleichshülse liegt an einem ersten Ende an dem Ventilgehäuse an. Ein beispielsweise plattenförmiges Verbindungselement ist mittels einer Feder an einem zweiten Ende der Ausgleichshülse und an einem zweiten Ende des piezoelektrischen Aktors in Anlage gehalten. Entsprechend einer alternativen zweiten vorteilhaften konstruktiven Lösung stützt sich der piezoelektrische Aktor an einem ersten Ende an dem Ventilgehäuse ab und die Ausgleichshülse ist an einem ersten Ende über eine Ventilnadel mit dem Ventilschließkörper verbunden. Dabei ist auch hier ein vorzugsweise plattenförmiges Verbindungselement mittels einer Feder an dem zweiten Ende der Ausgleichshülse und einem zweiten Ende des piezoelektrischen Aktors in Anlage gehalten.

### Zeichnung

Ausführungsbeispiele der Erfindung sind in der Zeichnung vereinfacht dargestellt und in der nachfolgenden Beschreibung näher erläutert. Es zeigen:
- Fig. 1: einen Schnitt durch ein erstes Ausführungsbeispiel eines erfindungsgemäßen Brennstoffeinspritzventils;
- Fig. 2: den Ausschnitt II in Fig. 1 in einer geschnittenen, detailierten Darstellung;
- Fig.3: den Ausschnitt II in Fig. 1 in einer geschnittenen, detailierten Darstellung entsprechend einem gegenüber Fig. 2 variierten Ausführungsbeispiel;
- Fig. 4: einen Schnitt durch ein erfindungsgemäßes Brennstoffeinspritzventil entsprechend einem weiteren Ausführungsbeispiel.

### Beschreibung der Ausführungsbeispiele

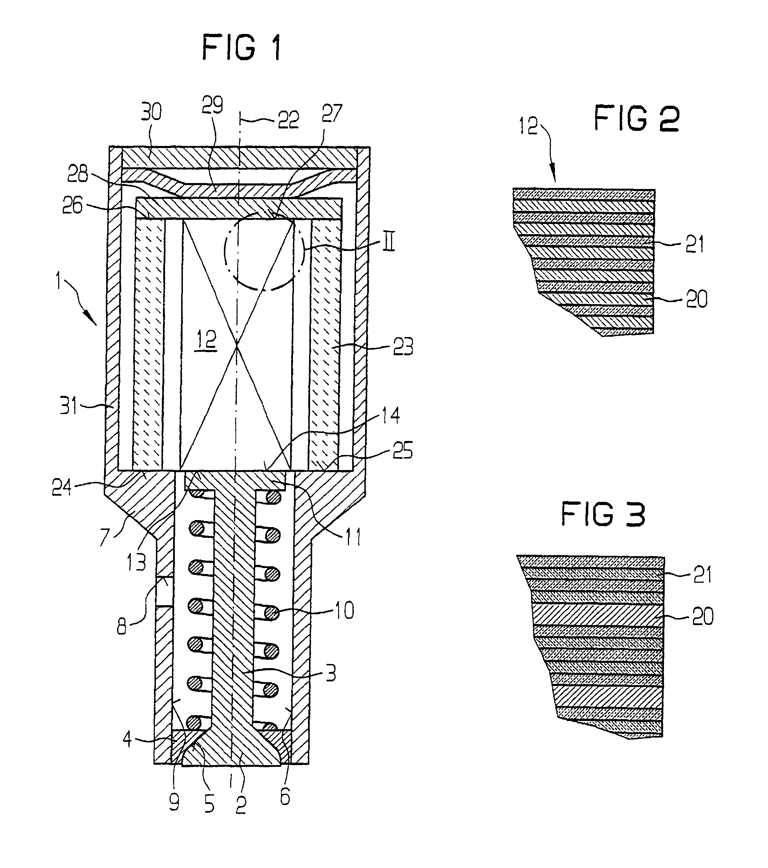

Ein erstes Ausführungsbeispiel eines erfindungsgemäßen Einspritzventils ist in Fig. 1 geschnitten dargestellt. Das allgemein mit dem Bezugszeichen 1 bezeichnete Brennstoffeinspritzventil dient zum Einspritzen von Brennstoff insbesondere bei einer fremdgezündeten, gemischverdichteten Brennkraftmaschine.

Das Brennstoffeinspritzventil 1 hat einen mit einer Ventilnadel 3 einstückig ausgebildeten Ventilschließkörper 2, der zusammen mit einem Ventilsitzkörper 4 einen Dichtsitz bildet. Bei dem in Fig. 1 dargestellten Ausführungsbeispiel des Brennstoffeinspritzventils 1 handelt es sich um ein nach außen öffnendes Brennstoffeinspritzventil 1. Eine Ventilsitzfläche 5 ist deshalb an der Außenseite des Ventilsitzkörpers 4 angeordnet.

Der Ventilsitzkörper 4 ist in eine axiale Längsbohrung 6 eines Ventilgehäuses 7 eingesetzt und beispielsweise durch Schweißen mit dem Ventilgehäuse 7 dicht verbunden. Die Zufuhr von Brennstoff erfolgt über eine BrennstoffEinlaßöffnung 8 in dem Ventilgehäuse 7 und wird über einen Federaufnahmeraum 9 dem von dem Ventilschließkörper 2 und dem Ventilsitzkörper 4 gebildeten Dichtsitz zugeführt. In dem durch die axiale Längsbohrung 6 des Ventilgehäuses 7 gebildeten Federaufnahmeraum 9 ist eine Rückstellfeder 10 angeordnet, die sich zwischen dem Ventilsitzkörper 4 und einem Flansch 11 der Ventilnadel 3 erstreckt. Die Rückstellfeder 10 überträgt auf die Ventilnadel 3 eine Rückstellkraft in Schließrichtung des Brennstoffeinspritzventils 1.

Die Betätigung der Ventilnadel 3 und des Ventilschließkörpers 2 erfolgt über einen piezoelektrischen Aktor 12, dessen erstes Ende 13 an einer Stirnfläche 14 des Flansches 11 der Ventilnadel 3 bündig anliegt. Bei einer elektrischen Erregung des piezoelektrischen Aktors 12 dehnt sich dieser in seiner axialen Längsrichtung aus und verschiebt die Ventilnadel 3 und den mit der Ventilnadel 3 einstückig ausgebildeten Ventilschließkörper 2 in Fig. 1 nach unten, so daß das Brennstoffeinspritzventil 1 öffnet. Nach Abschalten der elektrischen Erregungsspannung zieht sich der piezoelektrische Aktor 12 wieder zusammen, so daß der Ventilschließkörper 2 durch die Rückstellfeder 10 in seine Schließstellung zurückgeführt wird.

Die erfindungsgemäße Besonderheit besteht in dem Schichtaufbau des piezoelektrischen Aktors 12. Zur besseren Verdeutlichung der Erfindung ist ein erstes Ausführungsbeispiel des Schichtaufbaus des piezoelektrischen Aktors 12 in Fig. 2 vergrößert dargestellt.

Der piezoelektrische Aktor 12 besteht aus mehreren gestapelt angeordneten Piezo-Schichten 21 aus einem piezoelektrischen Material. Auf die Piezo-Schichten 21 sind in üblicher Weise Elektroden beispielsweise durch Aufsputtern oder Aufdampfen aufgebracht, so daß die Piezo-Schichten 21 mit einer elektrischen Spannung so beaufschlagt werden können, daß sich in den Piezo-Schichten 21 ein elektrisches Feld in Richtung der axialen Längsachse 22 des Brennstoffeinspritzventils 1 einstellt, welches eine Dehnung des piezoelektrischen Aktors 12 bewirkt.

Bekanntermaßen hängt jedoch die Dehnung bzw. Kontraktion der Piezo-Schichten 21 nicht nur von der angelegten elektrischen Feldstärke sondern auch wesentlich von der Temperatur ab. Piezoelektrische Materialien haben im Gegensatz zu gewöhnlichen Werkstoffen einen negativen Temperaturausdehnungs-Koeffizienten (α < 0), d.h. piezoelektrische Materialien ziehen sich mit zunehmender Temperatur zunehmend zusammen. Um einen durch Temperaturschwankungen hervorgerufenen unbeabsichtigten Ventilhub zu verhindern, ist diese temperaturabhängige Dehnung der Piezo-Schichten 21 zu kompensieren. Erfindungsgemäß sind deshalb zumindest eine, vorzugsweise jedoch mehrere Temperaturkompensations-Schichten 20 zwischen den Piezo-Schichten 21 angeordnet. Die Temperaturkompensations-Schichten 20 haben einen Temperaturausdehnungs-Koeffizienten, dessen Vorzeichen dem Temperaturausdehnungs-Koeffizienten der Piezo-Schichten 21 entgegengesetzt ist, d.h. die Temperaturkompensations-Schichten 20 bestehen aus einem Material mit einem positiven Temperaturausdehnungs-Koeffizienten (α > 0), wenn die Piezo-Schichten 21, wie üblich, einen negativen Temperaturausdehnungs-Koeffizienten (α < 0) haben. Durch eine geeignete Wahl der Anzahl der Temperaturkompensations-Schichten 20 und der Schichtdicke der Temperaturkompensations-Schichten 20 kann erreicht werden, daß die Summe der Kontraktionen bzw. Dehnungen sämtlicher Temperaturkompensations-Schichten 20 dem Betrag nach der Summe der Dehnungen bzw. Kontraktionen sämtlicher Piezo-Schichten 21 entspricht dem vorzeichen nach jedoch entgegengerichtet ist. Auf diese Weise wird eine wirkungsvolle Temperaturkompensation erreicht.

Bei dem in Fig. 2 dargestellten Ausführungsbeispiel ist in dem piezoelektrischen Aktor 12 jeweils alternierend eine Piezo-Schicht 21 und eine Temperaturkompensations-Schicht 20 sandwichartig angeordnet. Fig. 3 zeigt als ein vergrößerter Ausschnitt II in Fig. 1 einen piezoelektrischen Aktor 12 mit einem alternativen Schichtaufbau, bei welchem jeweils eine Temperaturkompensations-Schicht 20 zwischen mehreren Piezo-Schichten 21 angeordnet ist.

Als Material für die Temperaturkompensations-Schichten 20 eignet sich vorzugsweise ein Werkstoff mit einem großen positiven Temperaturausdehnungs-Koeffizienten, beispielsweise Aluminium, Kupfer oder ein geeignetes Kunststoffmaterial. Vorteilhaft sind auch Werkstoffe mit einer guten Wärmeleitfähigkeit und einer geringen Wärmekapazität, so daß sich die Temperatur der Temperaturkompensations-Schichten 20 schnell an die Temperatur der Piezo-Schichten 21 angleicht.

Wenn die Temperaturkompensations-Schichten 20 aus einem metallischen Werkstoff bestehen, können die Temperaturkompensations-Schichten 20 vorteilhaft gleichzeitig als Elektroden für die Piezo-Schichten 21 dienen.

Da die Temperaturkompensations-Schichten 20 in enger Nachbarschaft zu den Piezo-Schichten 21 angeordnet sind, ist eine schnelle Angleichung der Temperatur der Temperaturkompensation-Schichten 20 an die Temperatur der Piezo-Schichten 21 sichergestellt, so daß die Temperaturkompensation keiner wesentlichen Verzögerung unterworfen ist.

Durch die beschriebene erfindungsgemäße Maßnahme wird eine wirksame Temperaturkompensation des piezoelektrischen Aktors 12 erzielt, so daß der resultierende Temperaturausdehnungs-Koeffizient des piezoelektrischen Aktors 12 zumindest annähernd Null ist. Wenn sich der piezoelektrische Aktor 12 jedoch unmittelbar an einem festen Bauteil des Ventilgehäuses 7 abstützen würde, könnte durch die temperaturabhängige Ausdehnung bzw. Kontraktion der den Aktor 12 umgebenden Bereiche des Ventilgehäuses 7 dennoch eine unbeabsichtigte relative Verschiebung des Ventilsitzkörpers 4 in bezug auf den Ventilschließkörper 2 erfolgen, die zu einer unbeabsichtigten Ventilöffnung führen könnte. Erfindungsgemäß wird deshalb vorgeschlagen, auch die Wärmeausdehnung des Ventilgehäuses 7 zu kompensieren. Dazu ist eine Ausgleichshülse 23 vorgesehen, die den piezoelektrischen Aktor 12 umgibt. Die Ausgleichshülse 23 stützt sich mit einem ersten Ende 24 an einer Stufe 25 des Ventilgehäuses 7 ab. Das erste Ende 13 des piezoelektrischen Aktors 12 wirkt über die Ventilnadel 3, wie bereits beschrieben, auf den Ventilschließkörper 2 ein. Das dem ersten Ende 24 gegenüberliegende zweite Ende 26 der Ausgleichshülse 23 und das dem ersten Ende 13 gegenüberliegende zweite Ende 27 des piezoelektrischen Aktors 12 sind über ein Verbindungselement 28 miteinander verbunden, das im Ausführungsbeispiel plattenförmig ausgebildet ist. Das Verbindungselement 28 ist in dem Ventilgehäuse 7 in axialer Richtung bewegbar und wird mittels einer im Ausführungsbeispiel als Tellerfeder ausgebildeten Feder 29 sowohl an dem zweiten Ende 26 der Ausgleichshülse 23 als auch an dem zweiten Ende 27 des piezoelektrischen Aktors 12 in Anlage gehalten. Das Ventilgehäuse 7 ist durch eine Endplatte 30 abgeschlossen, an welcher sich die Feder 29 abstützt und die mit dem Hauptkörper 31 des Ventilgehäuses 7 beispielsweise durch Schweißen verbunden sein kann.

Die Ausgleichshülse 23 hat die gleiche axiale Länge wie der piezoelektrische Aktor 12 und besteht aus einem Werkstoff mit einem äußerst geringen Temperaturausdehnungs-Koeffizienten, vorzugsweise aus einem keramischen Werkstoff bzw, einem Glaswerkstoff. Da der piezoelektrische Aktor 12, wie beschrieben, temperaturkompensiert ist, sind sowohl die Ausgleichshülse 23 als auch der piezoelektrische Aktor 12 im wesentlichen keiner temperaturabhängigen Längenausdehnung unterworfen. Das Verbindungselement 28 befindet sich deshalb unabhängig von der Betriebstemperatur des Brennstoffeinspritzventils 1 bezüglich der Stufe 25 des Ventilgehäuses 7 stets in der gleichen axialen Position und zwar unabhängig von einer möglichen temperaturabhängigen Längenausdehnung, der die die Ausgleichshülse 23 und den piezoelektrischen Aktor 12 umgebenden Bereiche des Ventilgehäuses 7 unterworfen sind. Eine temperaturabhängige Dehnung dieser Bereiche des Ventilgehäuses 7 bewirkt deshalb keine relative axiale Verschiebung des Ventilsitzkörpers 7 gegenüber dem Ventilschließkörper 2. Wenn die Ventilnadel 3 und der Abschnitt zwischen der Stufe 25 und dem Ventilsitzkörper 4 des Ventilgehäuses 7 aus dem gleichen Material bestehen, bewirkt eine Temperaturänderung in diesem Bereich ebenfalls keine relative Lageveränderung des Ventilschließkörpers 2 gegenüber dem Ventilsitzkörper 4, so daß das Brennstoffeinspritzventil 1 insgesamt wirksam temperaturkompensiert ist.

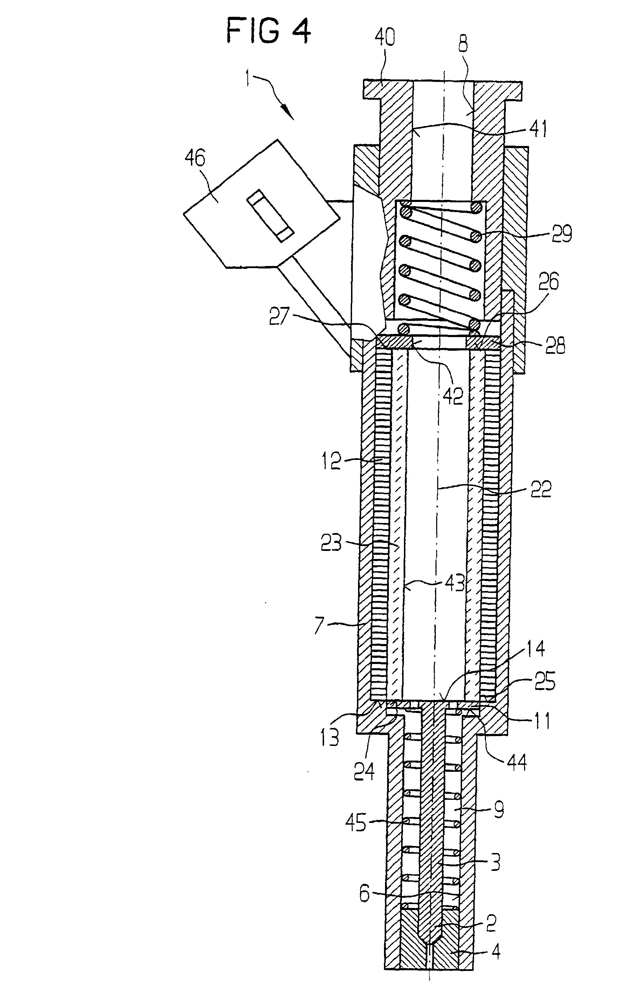

Fig. 4 zeigt ein weiteres Ausführungsbeispiel eines erfindungsgemäßen Brennstoffeinspritzventils 1. Bei dem in Fig. 4 gezeigten Ausführungsbeispiel ist die Temperaturkompensation bei einem nach innen öffnenden Brennstoffeinspritzventil 1 realisiert. Um die Zuordnung zu erleichtern, sind bereits beschriebene Elemente mit übereinstimmenden Bezugszeichen versehen, so daß sich insoweit eine wiederholende Beschreibung erübrigt.

Bei dem in Fig. 4 dargestellten Ausführungsbeispiel ist der piezoelektrische Aktor 12 hülsenförmig ausgebildet. Er hat jedoch den gleichen Schichtaufbau, wie dies in den Figuren 2 und 3 verdeutlicht ist, d.h. zwischen den Piezo-Schichten 21 sind Temperaturkompensations-Schichten 20 so angeordnet, daß der piezoelektrische Aktor 12 temperaturkompensiert ist. Der effektive Temperaturausdehnungs-Koeffizient des Aktors 12 ist daher im wesentlichen gleich Null. Auch bei dem in Fig. 4 dargestellten Ausführungsbeispiel ist eine vorzugsweise aus einem keramischen Werkstoff ausgebildete Ausgleichshülse 23 vorgesehen, die von dem piezoelektrischen Aktor 12 umgeben ist. Die Brennstoffeinlaßöffnung 8 ist an einem Brennstoffeinlaß-Stutzen 40 an dem dem Ventilsitzkörper 4 gegenüberliegendem Ende des Brennstoffeinspritzventils 1 ausgebildet. Die Zuleitung des Brennstoffs zu dem Dichtsitz erfolgt über eine Axialbohrung 41 des Brennstoffeinlaß-Stutzens 40, eine Ausnehmung 42 in dem plattenförmigen Verbindungselement 28, eine axiale Längsausnehmung 43 in der Ausgleichshülse 23, Durchlaßbohrungen 44 in dem Flansch 11 der Ventilnadel 3 und den Federaufnahmeraum 9. In dem Federaufnahmeraum 9 ist eine Mitnahmefeder 45 vorgesehen.

In Fig. 4 ist ferner ein Anschlußstecker 46 dargestellt, der zur elektrischen Kontaktierung des piezoelektrischen Aktors 12 dient. Der Anschlußstecker 46 kann beispielsweise als Kunststoffspritzgußteil ausgebildet sein.

Bei einer elektrischen Betätigung des piezoelektrischen Aktors 12 stützt sich dieser an seinem ersten Ende 13 an der Stufe 25 des Ventilgehäuses 7 ab und verschiebt das plattenförmige Verbindungselement 28 in Fig. 4 gegen die Feder 29 nach oben. Durch die Mitnahmefeder 45 wird der Flansch 11 der Ventilnadel 3 in Anlage an dem ersten Ende 24 der Ausgleichshülse 23 gehalten. Gleichzeitig wird das zweite Ende 26 der Ausgleichshülse 23 stets in Anlage an dem plattenförmigen Verbindungselement 28 gehalten. Die Ausdehnung des piezoelektrischen Aktors 12 bewirkt deshalb ein Anheben des Ventilschließkörpers 2 und somit ein Öffnen des Brennstoffeinspritzventils 1. Dabei ist wesentlich, daß die Federkraft der Feder 29 größer ist als die Federkraft der Mitnahmefeder 45. Beim Abschalten der elektrischen Erregungsspannung zieht sich der piezoelektrische Aktor 12 wieder zusammen, so daß die Feder 29 über das plattenförmige Verbindungselement 28, die Ausgleichshülse 23 und die Ventilnadel 3 den Ventilschließkörper 2 wieder in Anlage an den Ventilsitzkörper 4 bringt und somit das Brennstoffeinspritzventil 1 schließt.

Da die Ausgleichshülse 23 die gleiche axiale Länge wie der piezoelektrische Aktor 12 hat und sowohl der piezoelektrische Aktor 12 als auch die Ausgleichshülse 23 einen äußerst geringen Temperaturausdehnungs-Koeffizienten haben, ist der Ventilhub nahezu temperaturunabhängig. Insbesondere hat der den piezoelektrischen Aktor 12 und die Ausgleichshülse 23 umgebende Bereich des Ventilgehäuses 7 keinen Einfluß auf den Ventilhub, da dessen Wärmedehnung durch die Feder 29 ausgeglichen wird.

Zwischen dem Aktor 12 und der Ausgleichshülse 23 kann sowohl bei dem Ausführungsbeispiel der Fig. 1 als auch bei dem Ausführungsbeispiel der Fig. 4 eine Wärmeleitpaste zur verbesserten Wärmekopplung der Ausgleichshülse 23 und des Aktors 12 eingebracht werden.

Anstatt mit der Mitnahmefeder 45 kann die bündige Anlage des Flansches 11 der Ventilnadel 3 an dem ersten Ende 24 der Ausgleichshülse 23 und die bündige Anlage des zweiten Endes 26 des Ausgleichshülse 23 an dem plattenförmigen Verbindungselement 28 auch beispielsweise durch Verkleben oder Verpressen realisiert werden.

Da das Brennstoffeinspritzventil 1 entsprechend dem in Fig. 4 dargestellten Ausführungsbeispiel von dem Brennstoff zentral durchströmt wird, können rotationssymmetrische Bauteile zum Einsatz kommen, was eine kostengünstige Fertigung ermöglicht. Das von dem Brennstoff zentral durchströmte Brennstoffeinspritzventil 1 erfordert keine seitliche Brennstoffeinlaßöffnung 8. Daher ist der Einbau an einer Brennkraftmaschine unter Verwendung von üblicher hydraulischer Anschlußtechnik vereinfacht. Da keine verschleißbehafteten Teile zum Einsatz kommen, ergibt sich eine lange Lebensdauer des erfindungsgemäßen Brennstoffeinspritzventils 1.

## Patentansprüche

1. Brennstoffeinspritzventil (1) für Brennstoffeinspritzanlagen von Brennkraftmaschinen mit einem Ventilschließkörper (2), der mit einem Ventilsitzkörper (4) zu einem Dichtsitz zusammenwirkt, und einem piezoelektrischen Aktor (12) zur Betätigung des Ventilschließkörpers (2), der aus mehreren Piezo-Schichten (21) aus einem piezoelektrischen Material mit einem bestimmten Temperaturausdehnungs-Koeffizienten (α < 0) besteht, wobei der piezoelektrische Aktor (12) zusätzlich zu den Piezo-Schichten (21) eine oder mehrere Temperaturkompensations-Schichten (20) aufweist, die einen Temperaturausdehnungs-Koeffizienten (α > 0) haben, dessen Vorzeichen dem Temperaturausdehnungs-Koeffizienten (α < 0) der Piezo-Schichten (21) entgegengesetzt ist,
**dadurch gekennzeichnet,**
**daß** der piezoelektrische Aktor (12) von einer Ausgleichshülse (23) umgeben ist, die aus einem Material mit einem niedrigen Temperaturausdehnungs-Koeffizienten besteht, wobei die Ausgleichshülse (23) die axiale Lage des piezoelektrischen Aktors (12) in einem Ventilgehäuse (7) festlegt oder
**daß** der piezoelektrische Aktor (12) hülsenförmig ausgebildet ist und eine Ausgleichshülse (23) umgibt, die aus einem Material mit einem niedrigen Temperaturausdehnungs-Koeffizienten besteht, wobei die Ausgleichshülse (23) den piezoelektrischen Aktor (12) mit dem Ventilschließkörper (2) verbindet.

2. Brennstoffeinspritzventil nach Anspruch 1,
**dadurch gekennzeichnet,**
**daß** die Schichtdicken der Temperaturkompensations-Schichten (20) so bemessen sind, daß der piezoelektrische Aktor (12) keine oder zumindest eine möglichst kleine Längenänderung in Abhängigkeit von einer Temperaturänderung aufweist.

3. Brennstoffeinspritzventil nach Anspruch 1 oder 2,
**dadurch gekennzeichnet,**
**daß** jeweils alternierend eine Piezo-Schicht (21) und eine Temperaturkompensations-Schicht (20) in dem piezoelektrischen Aktor (12) sandwichartig angeordnet ist.

4. Brennstoffeinspritzventil nach Anspruch 1 oder 2,
**dadurch gekennzeichnet,**
**daß** jeweils eine Temperaturkompensations-Schicht (20) zwischen mehreren Piezo-Schichten (21) in dem piezoelektrischen Aktor (12) angeordnet ist.

5. Brennstoffeinspritzventil nach einem der Ansprüche 1 bis 4,
**dadurch gekennzeichnet,**
**daß** die Temperaturkompensations-Schichten (20) aus einem Material mit einem großen Temperaturausdehnungs-Koeffizienten, vorzugsweise aus Kupfer, Aluminium oder einem Kunststoff, bestehen.

6. Brennstoffeinspritzventil nach einem der Ansprüche 1 bis 5,
**dadurch gekennzeichnet,**
**daß** die Temperaturkompensations-Schichten (20) aus einem metallischen Material bestehen und gleichzeitig als Elektroden für die Piezo-Schichten (21) dienen.

7. Brennstoffeinspritzventil nach Anspruch 1,
**dadurch gekennzeichnet,**
**daß** der piezoelektrische Aktor (12) an einem ersten Ende (13) über eine Ventilnadel (3) mit dem Ventilschließkörper (2) verbunden ist,
**daß** die Ausgleichshülse (23) an einem ersten Ende (24) an dem Ventilgehäuse (7) anliegt, und
**daß** ein Verbindungselement (28) mittels einer Feder (29) an einem zweiten Ende (26) der Ausgleichshülse (23) und einem zweiten Ende (27) des piezoelektrischen Aktors (12) in Anlage gehalten ist.

8. Brennstoffeinspritzventil nach Anspruch 1,
**dadurch gekennzeichnet,**
**daß** der piezoelektrische Aktor (12) sich an einem ersten Ende (13) an einem Ventilgehäuse (7) abstützt,
**daß** die Ausgleichshülse (23) an einem ersten Ende (24) über eine Ventilnadel (3) mit dem Ventilschließkörper (2) verbunden ist, und
**daß** ein Verbindungselement (28) mittels einer Feder (29) an einem zweiten Ende (26) der Ausgleichshülse (23) und einem zweiten Ende (27) des piezoelektrischen Aktors (12) in Anlage gehalten ist.

9. Brennstoffeinspritzventil nach Anspruch 1 oder 8,
**dadurch gekennzeichnet,**
**daß** von dem Brennstoffeinspritzventil (1) abzuspritzender Brennstoff die Ausgleichshülse (23) durchströmt.

10. Brennstoffeinspritzventil nach einem der Ansprüche 1 bis 9,
**dadurch gekennzeichnet,**
**daß** die Ausgleichshülse (23) aus einem keramischen Material besteht.

11. Brennstoffeinspritzventil nach einem der Ansprüche 1 bis 10,
**dadurch gekennzeichnet,**
**daß** die Ausgleichshülse (23) die gleiche axiale Länge wie der piezoelektrische Aktor (12) hat.

## Claims

1. Fuel injection valve (1) for fuel injection systems of internal combustion engines, with a valve-closing body (2) which cooperates with a valve-seat body (4) to form a sealing seat, and with a piezoelectric actuator (12) for actuating the valve-closing body (2), the said piezoelectric actuator consisting of a plurality of piezoelectric layers (21) composed of a piezoelectric material with a defined coefficient of thermal expansion (α < 0), the piezoelectric actuator (12) having, in addition to the piezoelectric layers (21), one or more temperature-compensating layers (20) which have a coefficient of thermal expansion (α > 0), the sign of which is opposite to the coefficient of thermal expansion (α < 0) of the piezoelectric layers (21), **characterized in that** the piezoelectric actuator (12) is surrounded by a compensating sleeve (23) which consists of a material with a low coefficient of thermal expansion, the compensating sleeve (23) securing the axial position of the piezoelectric actuator (12) in a valve housing (7), or **in that** the piezoelectric actuator (12) has a sleeve-shaped design and surrounds a compensating sleeve (23) which consists of a material with a low coefficient of thermal expansion, the compensating sleeve (23) connecting the piezoelectric actuator (12) to the valve-closing body (2).

2. Fuel injection valve according to Claim 1, **characterized in that** the layer thicknesses of the temperature-compensating layers (20) are dimensioned such that the piezoelectric actuator (12) has no length change or at least as small a length change as possible as a function of a temperature change.

3. Fuel injection valve according to Claim 1 or 2, **characterized in that** a piezoelectric layer (21) and a temperature-compensating layer (20) are in each case alternately arranged in a sandwich-like manner in the piezoelectric actuator (12).

4. Fuel injection valve according to Claim 1 or 2, **characterized in that** in each case a temperature-compensating layer (20) is arranged between a plurality of piezoelectric layers (21) in the piezoelectric actuator (12).

5. Fuel injection valve according to one of Claims 1 to 4, **characterized in that** the temperature-compensating layers (20) consist of a material with a high coefficient of thermal expansion, preferably of copper, aluminium or a plastic.

6. Fuel injection valve according to one of Claims 1 to 5, **characterized in that** the temperature-compensating layers (20) consist of a metallic material and serve at the same time as electrodes for the piezoelectric layers (21).

7. Fuel injection valve according to Claim 1, **characterized in that** the piezoelectric actuator (12) is connected at a first end (13) to the valve-closing body (2) via a valve needle (3), **in that** the compensating sleeve (23) bears at a first end (24) on the valve housing (7), and **in that** a connection element (28) is held by means of a spring (29) in bearing contact on a second end (26) of the compensating sleeve (23) and on a second end (27) of the piezoelectric actuator (12).

8. Fuel injection valve according to Claim 1, **characterized in that** the piezoelectric actuator (12) is supported at a first end (13) on a valve housing (7), **in that** the compensating sleeve (23) is connected at a first end (24) to the valve-closing body (2) via a valve needle (3), and **in that** a connection element (28) is held by means of a spring (29) in bearing contact on a second end (26) of the compensating sleeve (23) and on a second end (27) of the piezoelectric actuator (12) .

9. Fuel injection valve according to Claim 1 or 8, **characterized in that** fuel to be injected by the fuel injection valve (1) flows through the compensating sleeve (23).

10. Fuel injection valve according to one of Claims 1 to 9, **characterized in that** the compensating sleeve (23) consists of a ceramic material.

11. Fuel injection valve according to one of Claims 1 to 10, **characterized in that** the compensating sleeve (23) has the same axial length as the piezoelectric actuator (12).

## Revendications

1. Injecteur de combustible (1) pour installations d'injection de combustible de moteurs à combustion interne, constitué d'un obturateur de soupape (2) qui coopère avec un siège de soupape (4) vers un siège d'étanchéité, et un actionneur piézoélectrique (12) pour actionner l'obturateur de soupape (2) constitué de plusieurs couches piézo (21) d'un matériau piézoélectrique présentant un certain coefficient de dilatation de température (α < 0), l'actionneur piézoélectrique (12) présentant, en plus des couches piézo (21), une ou plusieurs couches de compensation de température (20) qui ont un coefficient de dilatation de température (α > 0) dont le signe est à l'opposé du coefficient de dilatation de température (α < 0) des couches piézo (21),
**caractérisé en ce que**
l'actionneur piézoélectrique (12) est entouré d'une enveloppe de compensation (23) constituée d'un matériau présentant un coefficient de dilatation de température bas, l'enveloppe de compensation (23) fixant la position axiale de l'actionneur piézoélectrique (12) dans un boîtier de soupape (7), ou
l'actionneur piézoélectrique (12) est configuré en enveloppe et entoure une enveloppe de compensation (23) constituée d'un matériau qui présente un coefficient de dilatation de température bas, l'enveloppe de compensation (23) reliant l'actionneur piézoélectrique (12) l'obturateur de fermeture de soupape (2).

2. Injecteur de combustible selon la revendication 1,
**caractérisé en ce que**
l'épaisseur des couches des couches de compensation de température (20) est conçue de telle sorte que l'actionneur piézoélectrique (12) ne présente aucune modification linéaire ou, à tout le moins, la plus petite possible, en fonction d'une modification de température.

3. Injecteur de combustible selon la revendication 1 ou 2,
**caractérisé en ce que**
chaque fois en alternance, une couche piézo (21) et une couche de compensation de température (20) sont disposées en sandwich dans l'actionneur piézoélectrique (12).

4. Injecteur de combustible selon la revendication 1 ou 2,
**caractérisé en ce qu'**
une couche de compensation de température (20) est chaque fois disposées entre plusieurs couches piézo (21) dans l'actionneur piézoélectrique (12).

5. Injecteur de combustible selon l'une des revendications 1 à 4,
**caractérisé en ce que**
les couches de compensation de température (20) sont constituées d'un matériau présentant un coefficient important de dilatation de température, de préférence du cuivre, de l'aluminium ou une matière synthétique.

6. Injecteur de combustible selon l'une des revendications 1 à 5,
**caractérisé en ce que**
les couches de compensation de température (20) sont en un matériau en métal et servent, en même temps, d'électrodes pour les couches piézo (21).

7. Injecteur de combustible selon la revendication 1,
**caractérisé en ce que**
l'actionneur piézoélectrique (12) est relié à l'obturateur de soupape (2), sur une première extrémité (13) par une aiguille de soupape (3),
l'enveloppe de compensation (23) est raccordée sur une première extrémité (24) sur le boîtier de la soupape (7) et
un élément de liaison (28) est maintenu en place au moyen d'un ressort (29) sur une deuxième extrémité (26) de l'enveloppe de compensation (23) et sur une deuxième extrémité (27) de l'actionneur piézoélectrique (12).

8. Injecteur de combustible selon la revendication 1,
**caractérisé en ce que**
l'actionneur piézoélectrique (12) s'appuie sur une première extrémité ( 13) sur un boîtier de soupape (7),
l'enveloppe de compensation (23) est raccordée sur une première extrémité (24) par une aiguille de soupape (3) à l'obturateur de soupape (2), et
un élément de liaison (28) est maintenu en place au moyen d'un ressort (29) sur une deuxième extrémité (26) de l'enveloppe de compensation (23) et sur une deuxième extrémité (27) de l'actionneur piézoélectrique (12).

9. Injecteur de combustible selon la revendication 1 ou 8,
**caractérisé en ce que**
le combustible à injecter de l'injecteur (1), traverse l'enveloppe de compensation (23).

10. Injecteur de combustible selon l'une des revendications 1 à 9,
**caractérisé en ce que**
l'enveloppe de compensation (23) est en matériau céramique.

11. Injecteur de combustible selon l'une des revendications 1 à 10,
**caractérisé en ce que**
l'enveloppe de compensation (23) présente la même longueur axiale que l'actionneur piézoélectrique (12).
